**Europäisches Patentamt**

**European Patent Office**

**Office européen des brevets**

(11) Numéro de publication:

**0 040 567**

**B1**

(12) **FASCICULE DE BREVET EUROPEEN**

(45) Date de publication du fascicule du brevet: **13.11.85**

(51) Int. Cl.⁴: **H 01 P 1/26**

(21) Numéro de dépôt: **81400772.0**

(22) Date de dépôt: **15.05.81**

(54) Elément résistif en technique microbande.

(30) Priorité: **20.05.80 FR 8011226**

(43) Date de publication de la demande:
**25.11.81 Bulletin 81/47**

(45) Mention de la délivrance du brevet:
**13.11.85 Bulletin 85/46**

(84) Etats contractants désignés:
**DE GB IT**

(56) Documents cités:
**US-A-3 541 474**

**MICROWAVE JOURNAL, vol. 5, no. 10, octobre 1962, Dedham, US "New Products" "Filmohm develops thin stripline resistors", page 206 THIN SOLID FILMS, vol. 57, no. 2, mars 1979 Lausanne, CH "Electrical and Structural Properties of Tantalum Nitride Thin films Deposited by Sputtering", pages 333-336**

(73) Titulaire: **THOMSON-CSF
173, Boulevard Haussmann
F-75379 Paris Cedex 08 (FR)**

(72) Inventeur: **Bensussan, André
THOMSON-CSF SCPI 173, bld Haussmann
F-75360 Paris Cedex 08 (FR)**
Inventeur: **Girardat, Roland
THOMSON-CSF SCPI 173, bld Haussmann
F-75360 Paris Cedex 08 (FR)**

(74) Mandataire: **Weinmiller, Jürgen et al
Zeppelinstrasse 63
D-8000 München 80 (DE)**

(56) Documents cités:
**Compte rendu du "Colloque international sur la microélectronique avancée", tenu à Paris 6-10 avril 1970 (Ed. Union des Association techniques internationales et la Société Française des Electroniciens et des Radioélectriciens) Paris, FR P. LE MEN et al.: "Réalisation d'atténuateurs et de charges miniatures pour circuit microsriques" pages 254-262**

**EP 0 040 567 B1**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

## Description

L'invention concerne un élément résistif en technique microbande.

Dans le domaine des circuits réalisés en technique microbande pour la microélectronique, des problèmes particuliers se posent lorsque les fréquences de fonctionnement de ces circuits augmentent. En effet, pour les très hautes fréquences, supérieures à une dizaine de gigahertz, les ondes (dites centimètriques) ont une longueur d'onde inférieure à 3 cm. A ces fréquences, les dimensions des éléments de circuits sont du même ordre que la longueur d'onde. Par conséquent, ces éléments ne peuvent plus être considérés comme ponctuels. Cela est vrai en particulier pour les éléments résistifs.

Dans les circuits en technique microbande actuellement réalisés, les éléments résistifs sont constitués par des dépôts résistifs dont les dimensions, épaisseur, largeur et longueur, déterminent la valeur de la résistance. En général, l'épaisseur du dépôt est telle que, lorsque le dépôt résistif est carré, la valeur de sa résistance soit 50Ω. Dans ces conditions, la longueur L du dépôt par rapport à sa largeur W détermine la valeur de la résistance: R par exemple, Si L=0,5 W, R=25Ω et si L=2W, R=100Ω.

Cette technique permet de réaliser les charges utilisées sur certaines branches d'éléments réalisés en technique microbande tels que les coupleurs, les circulateurs, etc.

Comme indiqué ci-dessus, tant que les dimensions du dépôt résistif sont petites par rapport à la longueur d'onde utilisée, la résistance peut être considérée comme ponctuelle. D'autant que, si les puissances à dissiper sont assez faibles, les dimensions du dépôt résistif peuvent être faibles. Par contre, lorsque les puissances à dissiper augmentent, il est nécessaire d'augmenter la surface dissipative (la densité de puissance susceptible d'être dissipée étant de l'ordre de Watt par millimètre carré).

Par conséquent, il faut augmenter les dimensions du dépôt et la longueur du dépôt résistif n'est plus négligeable par rapport à la longueur d'onde. De plus, la largeur de ce dépôt résistif augmentant, il y a rupture d'impédance entre la ligne d'accès et la résistance et réflexion d'une partie de la puissance incidente. Lorsque la puissance à dissiper est assez grande et que la fréquence est élevée, par exemple lorsque le dépôt résistif doit dissiper 1W à une dizaine de gigahertz, d'autres inconvénients s'ajoutent à ceux indiqués ci-dessus. Si on veut conserver les dépôts résistifs ayant les formes décrites, les dimensions de la surface dissipative sont réduites (petite devant la longueur d'onde) d'où une densité de puissance dissipée par unité de surface élevée; ce qui introduit une température de fonctionnement très grande et qui entraîne un effet de vieillissement accéléré limitant la durée de vie de l'élément. Or les durées de vie de certains circuits réalisés en technique microélectronique pour des usages particuliers se chiffrent en millions d'heures. Dans de tels circuits, cet effet de vieillissement n'est pas tolérable. Pour limiter cet inconvénient, la technique actuelle consiste à former la résistance utile en mettant en série et en parallèle plusieurs dépôts résistifs rectangulaires tels que décrits ci-dessus.

Enfin, les retours à la masse de tels dépôts résistifs se font en général par des trous métallisés qui mettent le dépôt résistif réalisé sur une face d'un substrat en contact électrique avec le plan de masse réalisé sur l'autre face du substrat. Ces trous, à réaliser dans le substrat, augmentent le prix de revient de la charge.

Dans un article publié dans "The Microwave Journal", Octobre 1962, page 206 des résistances "stripline" sont décrites: elles comportent une base de mica et un film résistif dont la largeur est choisie en fonction de la largeur du conducteur correspondant et dont la longueur de l'élément est choisie, entre autres, en fonction de la puissance à dissiper. Lorsque ces résistances sont utilisées en bout de circuit, le dépôt résistif peut être aminci à une extrémité. Dans une telle résistance, la dissipation de puissance n'est pas non plus uniformément répartie.

L'invention a pour objet de résoudre le problème de la dissipation de puissance, en réalisant un élément résistif en technique microbande qui évite tous ces inconvénients, la forme du dépôt résistif étant adaptée d'une part à la largeur de la ligne d'accès d'autre part à la puissance dissipée, la puissance dissipée par unité de surface ou part unité de longueur de ligne étant constante ou quasi constante.

Suivant un mode de réalisation de l'invention, un élément résistif en technique microbande, formé sur un substrat diélectrique ayant sur l'une de ses grandes faces un dépôt conducteur formant plan de masse, constitué par une ligne résistive ouverte à son extrémité formée entre le plan de masse et un dépôt résistif déposé sur l'autre grande face du substrat, ce dépôt résistif étant couplé à une ligne d'accès et ayant une largeur diminuant vers le bout de cette ligne est caractérisé en ce quela largeur W de ce dépôt résistif diminue progressivement tout au long de la ligne résistive, en fonction de l'abscisse z correspondante le long de cette ligne, depuis une largeur initiale $W_0$ égale à la largeur de la ligne d'accès, suivant une loi telle que formulée dans les revendications 1, 2 et 3, respectivement.

L'invention sera mieux comprise et d'autres détails apparaîtront à l'aide de la description qui suit en référence auf figures annexées.

— La figure 1 représente un élément résistif selon l'art connu.
— la figure 2 représente un élément résistif ayant une largeur constante et des courbes correspondantes représentant la variation de l'attenuation et la variation de puissance le long de cet élément.
— La figure 3 représente un premier mode de réalisation de l'élément résistif suivant l'invention, dont la largeur diminue progressivement le long de la ligne, et des courbes correspondantes.

— La figure 4 représente un deuxiéme mode de réalisation de l'élément résistif suivant l'invention.

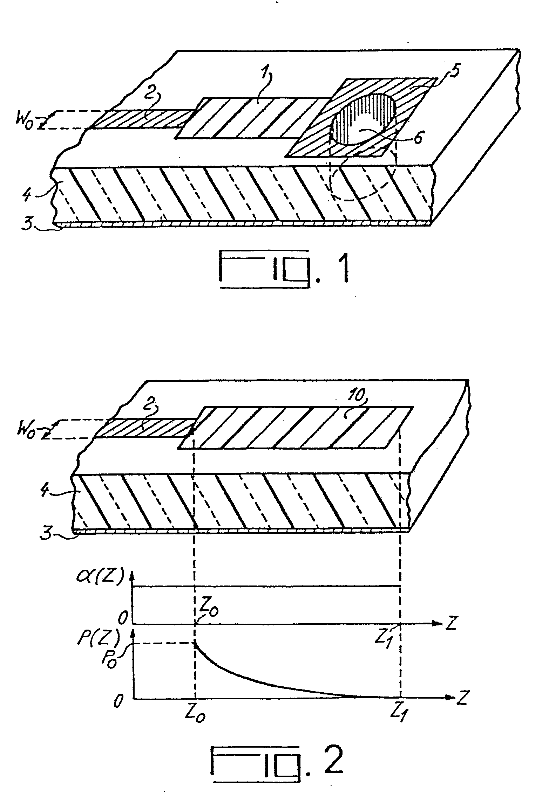

Sur la figure 1 a été représenté un élément résistif selon l'art conn. Cet élément résistif est constitué d'un dépôt résistif 1, couplé à la ligne d'accès formée par le ruban métallisé 2 et le plan de masse métallisé 3, déposés sur les deux faces d'un substrat diélectrique 4. Ce dépôt résistif 1 est relié électriquement au plan de masse par l'intermédiaire d'un trou effectué dans le substrat, un dépôt métallique conducteur 5 étant réalisé sur la première face du substrat et le trou 6 étant métallisé pour assurer la continuité électrique jusqu'au plan de masse 3.

Sur la figure 2 qui représente également un élément résistif connu le dépôt résistif 10 est rectangulaire, de longueur $L=Z_1-Z_0$ et de largeur constante $W_0$. Cet élément résistif est constitué par une ligne résistive à constantes réparties formée entre le plan de masse 3 et le dépôt résistif 10.

Sur une ligne à constantes réparties, le coefficient d'atténuation est par définition égal à :

$$(1) \qquad \alpha(z)=\frac{1}{P(z)}\ \frac{dP(z)}{dz}$$

ou $P(z)$ est la puissance dissipée le long de la ligne.

Par ailleurs, dans une ligne à constantes réparties fortement résistive, ce coefficient d'atténuation est de la forme

$$\alpha=\left(\frac{\omega rc}{2}\right)^{1/2},$$

$\omega$ etant la pulsation de l'onde incidente, $r$ et $c$ étant respectivement la resistance répartie et la capacité répartie par unité de longueur, toutes deux fonction de la largeur $W$ de la ligne, $c$ étant également fonction de l'épaisseur $h$ du substrat et $r$ étant également fonction de l'épaisseur $e$ du dépôt résistif. Ce coefficient d'atténuation peut être mis sur la forme :

$$(2) \qquad \alpha=K(W)^{-n},$$

où $K$ est une constante dépendant des différentes grandeurs indiquées ci-dessus et $n$ un exposant inférieur à 1 lié au materiau formant le substrat.

Si la largeur $W$ est constante, tout au long de la ligne, le coefficient d'atténuation $\alpha$ est également constant et la puissance dissipèe le long de la ligne suit une loi $P(z)=P_0e^{-\alpha z}$. Il faut noter que dans ce cas la puissance dissipée par unité de surface suit également une loi exponentielle.

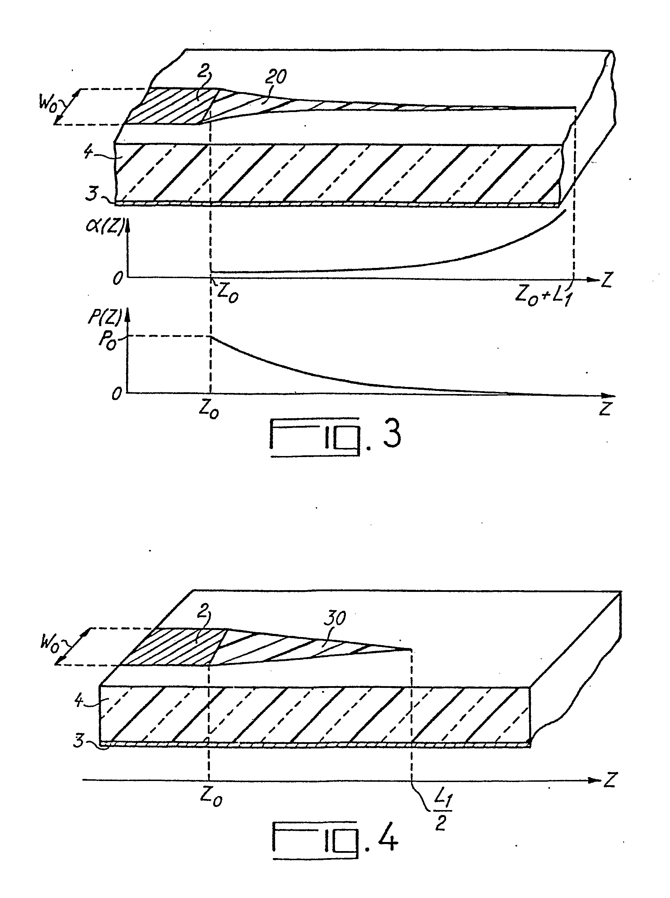

La figure 3 représente un dépôt résistif 20 dont la forme est définie pour que la densité de puissance dissipée par unité de surface soit constante sur l'ensemble de la surface du dépôt résistif.

Si $k$ est le coefficient de dissipation de puissance, par unité de surface, $k$ étant constant, la puissance dissipée varie le long de la ligne suivant l'expression :

$P(z)=kS(z)$ où $S(z)$ est la surface du dépôt résistif entre le début de la charge à l'abscisse $Z_0$ et l'abscisse $z$ quelconque le long du dépôt. Si $W(z)$ est la largeur du dépôt résistif, variable avec $z$, la puissance dissipée varie suivant la loi :

$$(3) \qquad P(z)=k\int_{z_0}^{z} W(z)dz\ \ et\frac{dP(z)}{dz}=k\ W(z).$$

Les expressions (1) et (2) donnent dans ces conditions :

$$(4) \qquad W(z)^{n+1}=K\int_{z_0}^{z} W(z)dz$$

Si $W(z)$ est de la forme :

$$(5) \qquad W(z)=W_0\left(1-\frac{z}{L_1}\right)^P$$

$L_1$ étant la longueur de la ligne l'égalité

$$(4) \quad \text{sera réalisée si } p=\frac{1}{n} \text{ et si} \frac{W_0^n}{KL_1}=\frac{n}{n+1} \qquad (6)$$

A partir d'une largeur de ligne $W_0$ donnée, un dépôt résistif dont le profil suit la loi $W(z)$ donnée par l'expression (5) avec

$$p=\frac{1}{n}$$

est tel que la puissance dissipée par unité de surface est constante, comme la température en chaque point de la charge. La longueur $L_1$ est déterminée à partir de $W_0$, $k$ et $n$ par l'expression (6), soit

$$L_1=\frac{1}{K}(\frac{n+1}{n})W_0^n$$

La puissance dissipée le long de la ligne suit alors une loi qui se déduit de celle de $W(z)$ par l'équation (3) soit :

$$(6) \qquad P(z)=P_0\left(1-\frac{z}{L_1}\right)^{n+1/n}$$

Le coefficient de dissipation $k$ peut être déterminé à partir de la surface de la charge :

$$k=\frac{P_0}{S}=\frac{n+1}{n}\ \frac{P_0}{W_0L_1}$$

Un tel profil de ligne conduit bien sûr à une dissipation par unité de longueur de ligne

$$\frac{dP(z)}{dz},$$

qui nest par constante le long de la ligne.

L'invention n'est pas limitée à ces modes de réalisation.

En particulier, dans certaines applications il pourrait être utile d'avoir non pas une densité de puissance dissipée par unité de surface constante, mais une dissipation constante par unité de longueur, soit

$$\frac{dP(z)}{dz},$$

constante.

Un calcul semblable à celui effectué ci-dessus, montre qu'alors le profil de la ligne doit être tel que

$$W(z)=W_o\left(1-\frac{z}{L_2}\right)^{1/n}.$$

Dans ce casla longueur $L_2$ est donnée par la formule

$$L_2=\frac{1}{K}W_o{}^n.$$

Ainsi, en fonction de la répartition de la puissance dissipée souhaitée, il est possible de modifier la forme du dépôt résistif.

Au lieu de modifier la forme du dépôt, il est théoriquement possible de modifier l'épaisseur de ce dépôt pour obtenir que la puissance dissipée varie selon une loi donnée. Cependant il est technologiquement assez difficile de faire varier l'épaisseur de ce dépôt en cours de fabrication. Une possibilité serait alors de modifier cette épaisseur a posteriori par des moyens mécaniques.

Comme indiqué ci-dessus, un élément résistif réalisé en technique microbande a, en particulier, l'avantage d'améliorer le taux d'onde stationnaire à l'entrée de la charge du fait qu'une certaine adaptation est réalisée. Ceci est surtout vrai si la puissance dissipée par unité de surface reste constante ou si la puissance par unité de longueur reste constante, car dans ces deux cas l'atténuation de la charge est infinie: il n'y a aucune puissance réfléchie de l'extrémité de la charge vers son entrée. De plus un tel élément résistif est très facile à réaliser du fait qu'il n'est plus nécessaire de prévoir un retour de masse par trou métallisé comme précédemment.

Enfin, les lois de variation de largeur indiquées ci-dessus se rapprochent d'un profil en triangle. En première approximation, il est donc possible d'obtenir un élément résistif de bonnes caractéristiques en donnant à la charge la forme d'un triangle. Ce mode de réalisation de l'élément résistif est représenté sur la figure 4.

En effet, comme le montre la figure 3, la plus grande partie de la puissance est absorbée après une fraction de la longueur $L_1$. Par exemple, pour un substrat d'alumine ayant une permittivité $\varepsilon_r=9,2$, d'épaisseur $h=0,635$ mm et un dépôt résistif formé de nitrure de tantale d'épaisseur $e=2000$ Å, la largeur de la ligne d'accès étant $W_o=0,6$ mm (ligne à 50Ω), pour une fréquence $F=7$ GHz, l'exposant $n=0,175$ et la longueur $L_1=23,7$ mm.

A une abscisse

$$z=\frac{L_1}{2},$$

la puissance retant à absorber est inférieure à

$$\frac{P_o}{10}.$$

Il est dont possible de limiter le dépôt résistif à une longueur égale à

$$\frac{L}{2},$$

par exemple, en suivant le profil dont l'équation est donnée ci-dessus. Il est également possible comme le montre la figure 4, de remplacer cette forme de dépôt par un triangle isocèle de base $W_o$ et de hauteur

$$\frac{L_1}{2},$$

30.

De tels éléments résistifs ne nécessitant par de retour de masse et permettant d'adapter les caractéristiques de l'élément résistif à celles de la ligne d'acces. Ils sont applicables en particulier pour réaliser les charges sur les accés non utilisés des coupleurs ou des circulateurs réalisés en technique microbande.

**Revendications**

1. Elément résistif en technique microbrande, formé sur un substrat diélectrique (4) ayant sur l'une de ses grandes faces un dépôt conducteur (3) formant plan de masse, constitué par une ligne résistive ouverte à son extrémité formée entre le plan de masse et un dépôt résistif déposé sur l'autre grande face du substrat, ce dépôt résistif étant couplé à une ligne d'accès et ayant une largeur diminuant vers le bout de cette ligne, caractérisé en ce que la largeur W de ce dépôt résistif (20) diminue progressivement tout au long de la ligne résistive en fonction de l'abscisse z correspondante le long de cette ligne depuis une largeur initiale $W_o$ égale à la largeur de la ligne d'accès (2), suivant la loi

$$W = W_o \left( 1 - \frac{z}{L_1} \right)^{1/n}$$

où n est un exposant inférieur à 1 caractéristique du diélectrique formant le substrat et où $L_1$ est la longueur de la ligne résistive (20) égale à

$$\frac{1}{K} \left( \frac{n+1}{n} \right) W_o^n,$$

K étant une constante fonction de l'épaisseur du substrat et de l'épaisseur du dépôt résistif, la puissance dissipée par unité de surface étant constante (Fig. 3).

2. Elément résistif en technique microbande, formé sur un substrat diélectrique (4) ayant sur l'une de ses grandes faces un dépôt conducteur (3) formant plan de masse, constitué par une ligne résistive ouverte à son extrémité formée entre le plan de masse et un dépôt résistif déposé sur l'autre grande face du substrat, ce dépôt résistif étant couplé à une ligne d'accès et ayant une largeur diminuant vers le bout de cette ligne, caractérisé en ce que la largeur W de ce dépôt résistif (20) diminue progressivement tout au long de la ligne résistive en fonction de l'abscisse z correspondante le long de cette ligne depuis une largeur initiale $W_o$ égale à la largeur de la ligne d'accès (2), suivant la loi

$$W = W_o \left( 1 - \frac{z}{L_2} \right)^{1/n},$$

où n est un exposant inférieur à 1 caractéristique du diélectrique formant le substrat et où $L_2$ est la longueur de la ligne résistive égale à

$$\frac{1}{K} W_o^n,$$

K étant une constante fonction de l'épaisseur du substrat et de l'épaisseur de dépôt résistif, la puissance dissipée par unité de longueur de ligne étant constante.

3. Elément résistif en technique microbande, formé sur un substrat diélectrique (4) ayant sur l'une de ses grandes faces un dépôt conducteur (3) formant plan de masse, constitué par une ligne résistive ouvertre à son extrémité formée entre le plan de masse et un dépôt résistif déposé sur l'autre grande face du substrat, ce dépôt résistif étant couplé à une ligne d'accès et ayant une largeur diminuant vers le bout de cette ligne, caractérisé en ce que la largeur W de ce dépôt résistif (30) diminue progressivement tout au long de la ligne résistive en fonction de l'abscisse z correspondante le long de cette ligne depuis une

largeur initiale $W_o$ égale à la largeur de la ligne d'accès (2), suivant une loi linéaire, jusqu'à atteindre 0 pour une longueur égale à

$$\frac{L_1}{2},$$

avec

$$L_1 = \frac{1}{K} \left( \frac{n+1}{n} \right) W_o^n,$$

où n est un exposant inférieur à 1 caractéristique du diélectrique formant le substrat et K une constante fonction de l'épaisseur du substrat et de l'épaisseur du dépôt résistif, la puissance dissipée par unité de surface étant quasiconstante (Fig. 4).

**Patentansprüche**

1. Mikrostrip-Widerstandselement, das auf ein dielektrisches Substrat (4) aufgebracht ist, dessen eine große Seite einen leitenden Belag (3) als Masseebene aufweist, wobei das Element aus einer am Ende offenen Widerstandsleitung besteht, die zwischen der Masseebene und einem auf der anderen großen Seite des Substrats aufliegenden und an eine Zugangsleitung gekoppelten Widerstandsbelag, dessen Breite zum Ende der Leitung hin abnimmt, ausgebildet ist, dadurch gekennzeichnet, daß die Breite W dieses Widerstandsbelags (20) stetig entlang der Widerstandsleitung abhängig von der entsprechenden Abszisse z entlang der Leitung von einer ursprünglichen Breite $W_o$ gleich der Breite der Zugangsleitung (2) nach dem Gesetz

$$W = W_o (1 - z/L_1)^{1/n}$$

abnimmt, wobei n ein Exponent kleiner 1 st, der für das Dielektrikum des Substrats charakteristisch ist, und die Länge $L_1$ der Widerstandsleitung (20) folgender Gleichung folgt

$$L_1 = \frac{1}{K} \left( \frac{n+1}{n} \right) W_o^n$$

wobei K eine von der Dicke des Substrats und der Dicke des Widerstandsbelags abhängige Konstante ist und wobei die pro Oberflächeneinheit abgeleitete Leistung konstant ist (Fig. 3).

2. Mikrostrip-Widerstandselement, das auf ein dielektrisches Substrat (4) aufgebracht ist, dessen eine große Seite einen leitenden Belag (3) als Masseebene aufweist, wobei das Element aus einer am Ende offenen Widerstandsleitung besteht, die zwischen der Masseebene und einem auf die andere große Seite des Substrats aufgebrachten Widerstandsbelag ausgebildet ist, dessen Breite zum Ende der Leitung hin abnimmt, dadurch gekennzeichnet, daß die Breite W dieses Widerstandsbelags (20) stetig entlang der Widerstandsleitung abhängig von der entsprechenden Abszisse z entlang dieser Leitung und ausgehend von einer ursprünglichen Breite $W_o$ gleich der Breite der Zugangsleitung (2) nach dem Gesetz abnimmt

$$W = W_o(1-z/L_2)^{1/n}$$

wobei n ein Exponent kleiner 1 ist, der für das das Substrat bildende Dielektrikum charakteristisch ist und wobei die Länge der Widerstandsleitung $L_2$ folgendem Gesetz gehorcht

$$L_2 = \frac{1}{K} W_o^n$$

wobei K eine von der Dicke des Substrats und der Dicke des Widerstandsbelags abhängige Konstante ist und die pro Längeneinheit der Leitung abgeleitete Leistung konstant ist.

3. Mikrostrip-Widerstandselement, das auf ein dielektrisches Substrat (4) aufgebracht ist, dessen eine große Seite einen leitenden Belag (3) als Masseebene aufweist, wobei das Element aus einer am Ende offenen Widerstandsleitung besteht, die zwischen der Masseebene und einem auf die andere große Seite des Substrats aufgebrachten Widerstandsbelag ausgebildet ist, der an eine Eingangsleitung gekoppelt ist und in seiner Breite zum Ende der Leitung hin abnimmt, dadurch gekennzeichnet, daß die Breite W diese Widerstandsbelags (30) stetig entlang der Widerstandsleitung abhängig von der entsprechenden Abszisse z entlang dieser Leitung und ausgehend von einer ursprünglichen Breite $W_o$ gleich der Breite der Zugangsleitung (2) nach einem linearen Gesetz so abnimmt, daß die Breite null bei einer Länge gleich $L_1/2$ erreicht ist, wobei

$$L_1 = \frac{1}{K}\left(\frac{n+1}{n}\right) W_o^n \;,$$

wobei n ein Exponent kleiner 1 ist, der für das das Substrat bildende Dielektrikum charackteristisch ist, und K eine von der Dicke des Substrats und der Dicke des Widerstandsbelags abhängige Konstante ist und wobei die pro Oberflächeneinheit abgeleitete Leistung quasi konstant ist (Fig. 4).

**Claims**

1. Resistive element using the microstrip technique and realized on a dielectric substrate (4), one large surface of this substrate being covered with a conductive layer (3) constituting the mass plane, the element being constituted by a resistive line, which is open at its end and which is built up between the mass plane and a resistive layer coated on the other large surface of the substrate, this resistive layer being coupled to an access line and having a width which decreases in the direction of the end of said line, characterized in that the width W of this resistive layer (20) decreases progressively along the resistive line in dependence of the corresponding abscissa z along this line from an initial width $W_o$ equal to the width of the access line (2) according to the law

$$W = W_o(1-z/L_1)^{1/n}$$

in which n is an exponent smaller than 1 indicative of the kind of dielectric from which the substrate is made, and in which the length $L_1$ of the resistive line (20) is equal to

$$L_1 = \frac{1}{K}\left(\frac{n+1}{n}\right)W_o^n$$

K being a constant value depending on the thickness of the substrate and the thickness of the resistive layer, the dissipated power per surface unit being constant (fig. 3).

2. Resistive element using the microstrip technique and realized on a dielectric substrate (4), one large surface of this substrate being covered with a conductive layer (3) constituting the mass plane, the element being constituted by a resistive line, which is open at its end and which is built up between the mass plane and a resistive layer coated on the other large surface of the substrate, this resistive layer being coupled to an access line and having a width which decreases in the direction of the end of said line, characterized in that the width W of this resistive layer (20) decreases progressively along the resistive line in dependence of the corresponding abscissa z along this line from an initial width $W_o$ equal to the width of the access line (2) according to the law

$$W = W_o(1-z/L_2)^{1/n}$$

in which n is an exponent smaller than 1 indicative of the kind of dielectric from which the substrate is made, and in which the length $L_2$ of the resistive line is equal to

$$\frac{1}{K}W_o^n,$$

K being a constant value depending on the thickness of the substrate and the thickness of the resistive layer, the dissipated power per length unit being constant.

3. Resistive element using the microstrip technique and realized on a dielectric substrate (4), one large surface of this substrate being covered with a conductive layer (3) constituting the mass plane, the element being constituted by a resistive line, which is open at its end and which is built up between the mass plane and a resistive layer coated on the other large surface of the substrate, this resistive layer being coupled to an access line and having a width which decreases in the direction of the end of said line, characterized in that the width W of this resistive layer (30) decreases progressively along the resistive line in dependence of the corresponding abscissa z along this line from an initial width $W_o$ equal to the width of the access line (2) according to a linear law up to reaching 0 for a length equal to $L_1/2$, with

$$L_1 = \frac{1}{K}\left(\frac{n+1}{n}\right)W_o^n \; ,$$

in which n is an exponent smaller than 1 indicative of the kind of dielectric from which the substrate is made and K is a constant value depending on the thickness of the substrate and the thickness of the resistive layer, the dissipated power per surface unit being constant (fig. 4).

Fig. 1

Fig. 2

Fig. 3

Fig. 4